# EUROPÄISCHE PATENTSCHRIFT

(11) **EP 1 697 555 B1**
(45) Veröffentlichungstag und Bekanntmachung des Hinweises auf die Patenterteilung: **10.02.2010**
(21) Anmeldenummer: 04820407.7
(22) Anmeldetag: 29.11.2004
(51) Int. Cl.: C23C 14/34, C23C 14/35, C23C 14/56, C23C 14/08

(54) **VERFAHREN UND VORRICHTUNG ZUM MAGNETRONSPUTTERN**
METHOD AND DEVICE FOR MAGNETRON SPUTTERING
PROCEDE ET DISPOSITIF DE PULVERISATION AU MAGNETRON

(30) Priorität: 18.12.2003 DE 10359508
(43) Veröffentlichungstag der Anmeldung: 06.09.2006
(73) Patentinhaber: Fraunhofer-Gesellschaft zur Förderung der angewandten Forschung e.V., 80686 München (DE)
(72) Erfinder: SZYSZKA, Bernd, 38108 Braunschweig (DE); PFLUG, Andreas, 38124 Braunschweig (DE)
(86) Internationale Anmeldenummer: PCT/EP2004/013532
(87) Internationale Veröffentlichungsnummer: WO 2005/059197

(56) Entgegenhaltungen:
- EP-A- 0 291 044
- EP-A- 0 537 011
- DE-A1- 4 418 906
- BARANOV A ET AL: "IN SITU X-RAY REFLECTIVITY FOR THIN-FILM DEPOSITION MONITORING AND CONTROL" SOLID STATE TECHNOLOGY, COWAN PUBL.CORP. PORT WASHINGTON, NY, US, Bd. 42, Nr. 5, Mai 1999 (1999-05), Seiten 53,55-56,58, XP000822947 ISSN: 0038-111X
- VERGOHL M ET AL: "Real time control of reactive magnetron-sputter deposited optical filters by in situ spectroscopic ellipsometry" THIN SOLID FILMS, ELSEVIER-SEQUOIA S.A. LAUSANNE, CH, Bd. 377-378, 1. Dezember 2000 (2000-12-01), Seiten 43-47, XP004226666 ISSN: 0040-6090
- VERGOHL M ET AL: "In situ monitoring of optical coatings on architectural glass and comparison of the accuracy of the layer thickness attainable with ellipsometry and photometry" THIN SOLID FILMS, ELSEVIER-SEQUOIA S.A. LAUSANNE, CH, Bd. 392, Nr. 2, 30. Juli 2001 (2001-07-30), Seiten 258-264, XP004250749 ISSN: 0040-6090

## Beschreibung

Die Erfindung betrifft ein Verfahren und eine Vorrichtung zum Magnetronsputtern. Diese Techniken werden zur Abscheidung von Funktions- und Veredelungsschichten verwendet. Magnetronsputtertechniken werden bereits in großem Maßstab, beispielsweise für die Beschichtung von Architekturglas, in der industriellen Fertigung eingesetzt.

Von besonderer technischer Bedeutung sind Beschichtungsprozesse, bei welchen die Beschichtung aus mehreren chemischen Elementen zusammengesetzt ist. Als Beispiel sei Titandioxid genannt. Bei solchen Beschichtungsprozessen wird oftmals die metallische Komponente durch Zerstäuben eines metallischen Targets bereitgestellt. Die weitere Schichtkomponente wird gasförmig in die Prozesskammer eingeleitet. Bei diesen sogenannten reaktiven Beschichtungsprozessen können hohe Beschichtungsraten und optimale Schichtqualität nur dann erreicht werden, wenn der Prozess im Bereich instabiler Arbeitspunkte betrieben wird. Dieser sogenannte Transition Mode zeichnet sich dadurch aus, dass die Reaktivgaszufuhr einerseits groß genug ist um eine ausreichende Menge an Reaktivgas für die Schichtabscheidung bereit zu stellen. Andererseits ist die zugeführte Menge an Reaktivgas jedoch so gering, dass eine Kontamination des Sputtertargets mit Reaktivgas vermieden wird. Gleichbleibende Qualität und Reproduzierbarkeit der Beschichtung setzen gerade bei diesen instabilen Arbeitspunkten den Betrieb der Magnetronsputteranlage mit Hilfe komplexer Regelschleifen voraus.

Magnetronsputterquellen lassen sich nach dem Stand der Technik durch die zugeführte elektrische Leistung oder den Reaktivgasfluss beeinflussen. Das notwendige Regelsignal kann durch Messung verschiedener Parameter erhalten werden. So wird beispielsweise in der EP 1 232 293 B1 vorgeschlagen, den Oberwellenanteil der elektrischen Parameter der Entladung als Regelgröße zu verwenden.

Aus der EP 0 795 623 A1 ist bekannt, den Partialdruck von Reaktivgasen mit geeigneten Sonden zu bestimmen. So kann beispielsweise der mit einer Lamda-Sonde gemessene Sauerstoffpartialdruck als Regelgröße verwendet werden. Aus J. Affinito et al., J. Vac. Sci. Technol. A 2 (1984), S. 1275-1284 ist bekannt, eine Magnetronsputterquelle durch Messung der Plasmaimpedanz zu regeln. Die Dissertation von J. Strümpfel, "Prozessstabilisierung beim reaktiven Hochratenzerstäuben mittels optischer Emissionsspektroskopie zur industriellen Herstellung von Indium-Zinn-Oxidschichten und Titandioxidschichten", Chemnitz 1991, beschreibt als weitere Möglichkeit die Messung der Intensität ausgewählter Spektrallinien des Plasmas der Magnetronsputterquellen.

Weiterhin ist die Abscheiderate einer MagnetronSputterquelle, welche im instabilen Übergangsbereich betrieben wird, nicht absolut bekannt. Daher müssen die Schichtdicken der hergestellten Schichten auf dem Substrat nach der Abscheidung bestimmt werden. In erster Linie werden hierzu optische Messungen wie Fotometrie oder Ellipsometrie verwendet.

Um eine gleichbleibende Schichtqualität, einen gleichbleibenden Schichtaufbau und eine gleichbleibende Schichtdicke zu gewährleisten, ist der beschriebene apparative Aufwand für jede einzelne Sputterquelle einer Beschichtungsanlage notwendig. Hieraus resultieren zum einen hohe Kosten in Anschaffung und Betrieb der Beschichtungsanlage als auch eine große Störanfälligkeit. Dies gilt insbesondere für große In-linesysteme.

In solchen In-linesystemen wird die Beschichtung von Stahlbandsubstraten oder Architekturglas im Durchlaufverfahren großtechnisch durchgeführt. Solche Beschichtungsanlagen verfügen über eine große Anzahl von Magnetron-Sputterquellen. Typisch sind hierbei zwanzig bis etwa dreißig Quellen, es sind jedoch auch Anlagen mit bis zu sechzig Magnetron-Sputterquellen im Einsatz. Entscheidend für die industrielle Fertigung ist dabei das Zusammenspiel all dieser einzelnen Sputterquellen, wobei häufig mehrere Quellen ein und das selbe Material abscheiden. Nur durch sehr großen Aufwand ist es dabei möglich, dass alle Quellen im Hinblick auf Schichteigenschaften, Beschichtungsrate und Homogenität identische Ergebnisse liefern.

Eine optische Messung der Schichteigenschaften nach jeder Sputterquelle erweist sich als außerordentlich schwierig. Neben hohen Kosten macht insbesondere die hohe Störanfälligkeit dieses Gesamtsystems, welches eine Vielzahl optischer Messsysteme aufweist, solche Verfahren in der Praxis nicht anwendbar.

Der Stand der Technik nach EP 0 291 044 A2 beschreibt ein Verfahren zur Herstellung einer Dünnschicht aus einem keramischen Hochtemperatursupraleiter. Dazu wird ein gesintertes Target aus Barium-Yttrium-Kupferoxid in einem Magnetron gesputtert. Da die Sputterrate für die verschiedenen Elemente des Targets unterschiedlich ist, kann die Lebensdauer des Targets vergrößert werden, wenn das Target selbst wiederum mit Kupfer und Barium bedampft wird. Hierzu dreht sich das Target kontinuierlich zwischen einer Sputterposition und einer Bedampfungsposition.

Aus der DE 44 18 906 A1 ist bekannt, eine Beschichtungsanlage mit einem Gehäuse vorzusehen, welches in eine Sputterkammer zum Beschichten eines Substrates und eine Targetträgerbeschichtungskammer zum kontinuierlichen Beschichten eines in beide Kammern ragenden, umlaufenden Targetträgers aufgeteilt ist. Auf diese Weise kann das Sputtertarget ständig neu beschichtet werden, und seine Lebensdauer wird erhöht. Dadurch können die Prozesszyklen deutlich verlängert werden, ohne dass die Sputterkammer belüftet werden muss.

Der Erfindung liegt daher die Aufgabe zugrunde, eine Sputterquelle anzugeben, welche ohne Kontrolle der abgeschiedenen Schicht und ohne aufwändige Regelschleifen die Abscheidung von Schichten mit definierten Eigenschaften und mit definierten Beschichtungsraten ermöglicht. Weiterhin besteht die Aufgabe darin, eine Sputterquelle anzugeben, welche für hochbrechende Materialien wie Titandioxid eine im Vergleich zum Stand der Technik erhöhte Beschichtungsrate aufweist.

Die Aufgabe wird gelöst durch eine Magnetronbeschichtungsanlage gemäß dem unabhängigen Anspruch eins und einem Verfahren zur Abscheidung dünner Schichten gemäß dem unabhängigen Anspruch 6. Bevorzugte Ausgestaltungen finden sich in den jeweiligen Unteransprüchen.

Die erfindungsgemäße Magnetronbeschichtungsanlage besteht aus einer ersten Beschichtungsquelle, einem Hilfssubstrat, welches zwischen dieser ersten Beschichtungsquelle und dem Bereich, welcher zur Aufnahme des zu beschichtenden Substrates vorgesehen ist, angeordnet ist, so wie einem Magnetron. Dabei sind Mittel zur Bestimmung der Massenbelegung dieses Hilfssubstrates vorgesehen und das Hilfssubstrat bildet eine Kathode für das genannte Magnetron.

Zur Abscheidung einer Schicht auf einen Substrat wird demnach zunächst mittels der ersten Beschichtungsquelle eine Schicht mit bekannter Abscheiderate auf ein Hilfssubstrat abgeschieden. Dieses Hilfssubstrat dient nun als Sputterkathode zur Beschichtung des Substrates mittels des Magnetrons. Dabei kann selbstverständlich nicht nur die auf das Hilfssubstrat abgeschiedene Schicht abgetragen werden, sondern auch das Material des Hilfssubstrates selbst. Beide Materialien bilden in diesem Fall, gegebenenfalls zusammen mit einer gasförmig zugeführten Komponente, die endgültige Schicht auf dem Substrat.

Nach der Bestimmung der Massenbelegung des Hilfssubstrates kann die Massenbelegung des Substrates aus der Massenbilanz des Hilfssubstrats bestimmt werden. Als erste Beschichtungsquelle eignet sich z.B. ein planares Magnetron, eine lineare Ionenquelle, welche ein Target zerstäubt oder Xenon oder Krypton implantiert, eine Linearquelle, die auf dem Prinzip der Laser-Ablation aufbaut oder eine lineare Verdampfungsquslle.

Vorzugsweise ist das Hilfssubstrat als rotierender, zylindrischer Körper ausgeführt. Somit können diejenigen Flächen, welche der ersten Beschichtungsquelle zugewandt sind kontinuierlich mit einer Beschichtung versehen werden während gleichzeitig diejenigen Flächenelemente, welche dem Substrat zugewandt sind, kontinuierlich als Sputterkathode zur Beschichtung des Substrates zur Verfügung stehen. Das Hilfssubstrat ist demnach Bestandteil eines Stabkathodenmagnetrons. Das zylinderförmige Hilfssubstrat kann im Innenbereich hohl sein und damit rohrförmig oder aber als massiver Stab ausgeführt werden. Durch die Rotation des Hilfssubstrates wird das vom ersten Magnetron abgesputterte Material kontinuierlich zum Substrat transportiert und dort abgeschieden.

In einer besonders vorteilhaften Ausführung handelt es sich bei der ersten Beschichtungsquelle um ein planares Magnetron. Dabei wird dieses erste Magnetron in einer reinen Schutzgasatmosphäre betrieben. Somit kann die Beschichtungsrate aus der bekannten Sputterrate sowie aus den elektrischen Entladungsparametern absolut bestimmt werden. Wird nun das zweite Magnetron mit Reaktivgas oder einer Mischung aus Inert- und Reaktivgas betrieben, so kann die Beschichtungsrate des Substrates aufgrund des stets veränderlichen Reaktivgaspartialdrucks an dieser Stelle nur unzureichend quantifiziert werden. Nach der Bestimmung der Massenbelegung am Hilfssubstrat kann jedoch die Beschichtungsrate des Substrates aus der Massenbilanz des Hilfssubstrates absolut bestimmt werden.

Fallweise kann die erste Beschichtungsquelle in einer Abschirmung angeordnet sein, um das Eindringen von Reaktivgaskomponenten, welche die Beschichtungsquelle verunreinigen würden, zu verhindern.

Vorteilhaft wird die Massenbelegung des Hilfssubstrates mittel Röntgenfloressenz bestimmt. Insgesamt kann auf diese Weise die Beschichtungsrate des Substrates mit einem Fehler von weniger als 0.1% bestimmt werden.

Als Inertgas zum Betrieb des ersten Magnetrons eignet sich insbesondere Argon. Dieses ist ohne großen technischen Aufwand und kostengünstig verfügbar. Darüber hinaus weist Argon als Edelgas ein hohes Ionisierungspotential auf und bleibt auch bei hohen Temperaturen inert. Als Reaktivgas eignet sich insbesondere Stickstoff und/oder Sauerstoff und/oder Methan. Damit lassen sich in Verbindung mit einen metallischen Sputtertarget Nitride, Oxide oder Karbide als dünne Schicht auf dem Substrat abscheiden.

Als metallisches Target eignet sich insbesondere eine auf dem Hilfssubstrat abgeschiedene Metallschicht von weniger als 100 Nanometern, besonders bevorzugt eine Schicht von weniger als 10 Nanometer dicke. Aus S. Berg, J. Vac. Sci. Technol. A 10 (1992), S. 1592-1596 ist bekannt, dass die Sputterrate von Materialien mit implantierten Schweratomen im Vergleich zur Sputterrate des reinen Materials eine deutliche Überhöhung aufweist. Somit können mit der erfindungsgemäßen Magnetron-Beschichtungsanlage auch bei Betriebszuständen außerhalb des Transition Modes hohe Abscheideraten erzielt werden. Für Materialien mit hohen Brechungsindex, wie z.B. Titandioxid, erlaubt die erfindungsgemäße Vorrichtung die Beschichtungsrate um mehr als 50% zu steigern.

Eine besonders hohe Steigerung der Beschichtungsrate ergibt sich demnach dann, wenn die mittels des ersten Magnetrons abgeschiedene Metallschicht eine größere Massenzahl aufweist, als die durchschnittliche Massenzahl des Materials des Hilfssubstrates. So ist beispielsweise die Sputterrate einer 2 nm dicken Schicht Wolfram auf einem Hilfssubstrat aus Aluminium bis zu einem Faktor 3 größer als die Sputterrate eines homogenen Wolframtargets.

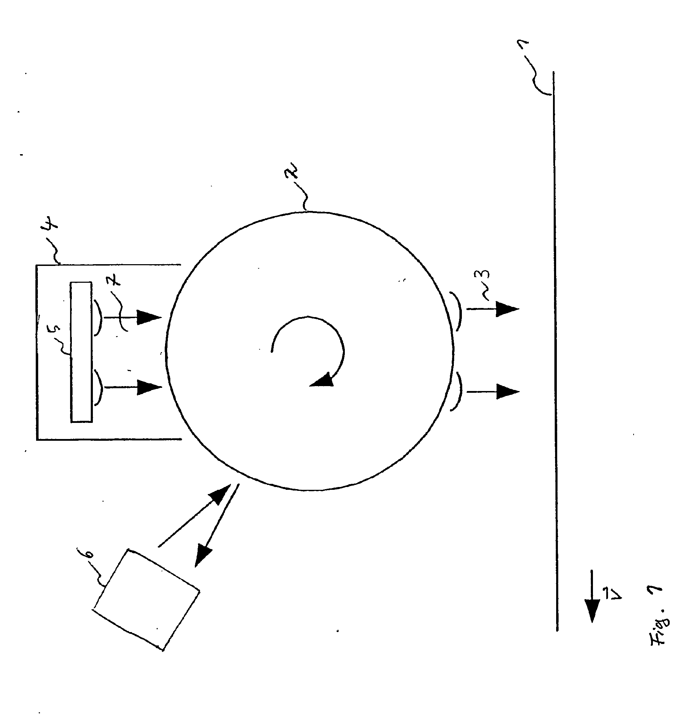

Das zweite Magnetron kann, wie aus dem Stand der Technik bekannt, als Einzelmagnetron mit Gleichspannung oder mit gepulster Gleichspannung betrieben werden. Vorteilhafterweise wird jedoch die erfindungsgemäße Vorrichtung als Doppelmagnetron mit einer Wechselspannung von etwa 10 kHz bis etwa 100 kHz betrieben. Besonders vorteilhaft ist der Betrieb mit einer Frequenz von 40 kHz. Beim Betrieb als Doppelmagnetron werden zwei der in Figur 1 gezeigten Anordnungen mit den Polen einer Wechselspannungsquelle verbunden. Damit wird jedes Hilfssubstrat abwechselnd als Anode und Kathode geschaltet. Durch den abwechselnden Elektronenbeschuss der Hilfssubstrate erfolgt eine effektive Einigung der Oberflächen der Hilfssubstrate. Dies vergrößert wunschgemäß die Prozessstabilität. Weiterhin führt der Betrieb von mindestens zwei Hilfssubstraten als Doppelmagnetron zu einer größeren Plasmadichte und damit wunschgemäß zu verbesserten Schichteigenschaften.

Die erfindungsgemäße Magnetronbeschichtungsanlage bietet somit erstmals die Möglichkeit, mit Hilfe der eingebauten Messtechnik das Erreichen einer vorgegebenen Schichtdicke auf einfachem Wege zu überwachen. Mit Hilfe dieser Technologie können auch große In-line Sputveranlagen mit einer Vielzahl von Beschichtungsstationen realisiert werden, welche mit den bisher verfügbaren Regelungsverfahren und optischen Diagnosesystemen nicht handhabbar waren.

Nachfolgend wird die Erfindung anhand einer Figur beispielhaft erläutert.

Figur 1 zeigt den schematischen Aufbau eines Magnentronbeschichtungsmoduls gemäß der vorliegenden Erfindung.

Die Figur zeigt in ihrem zentralen Teil ein zylindrisches Hilfssubstrat 2, welches um seine Längsachse rotiert. Unterhalb des zylindrischen Hilfssubstrates ist das zu beschichtende Substrat 1 angeordnet. Bei diesem Substrat kann es sich beispielsweise um Architekturglas handeln. Das Substrat 1 wird unterhalb der Beschichtungsanlage hindurch bewegt. Durch eine an das Hilfssubstrat 2 angelegte Spannung wird im Bereich 3 zwischen dem Hilfssubstrat 2 und dem Substrat 1 Plasma gezündet. Das Hilfssubstrat bildet somit eine Stabkathode, von welcher Material abgesputtert wird, welches das als Anode geschaltete Substrat 1 beschichtet. Im Bereich 3 befindet sich eine Mischung aus Inert- und Reaktivgas, welche die Abscheidung einer mehrkomponentigen Schicht erlaubt. Auf der entgegengesetzten Seite des Hilfssubstrates 2 befindet sich ein planares Magnetron 5 in einer Abschirmung 4. In diesem Fall ist das Hilfssubstrat 2 als Anode geschaltet, welche im Plasmabereich 7 mit Material der planaren Sputterkathode 5 beschichtet wird. Die Gasphase im Bereich 7 enthält ausschließlich Inertgas, so dass die Abscheiderate im Bereich 7 aus den bekannten Sputterraten und den elektrischen Parametern bestimmbar ist. Die Beschichtungsrate auf dem Substrat 1 ergibt sich aus der Massenbilanz am Hilfssubstrat 2. Neben der bekannten Beschichtungsrate im Bereich 7 wird hierzu noch die Massenbelegung nach dem Sputterprozess im Bereich 3 benötigt. Hierzu befindet sich eine Einrichtung zur Bestimmung der Röntgenfloressenz 6 hinter der Plasmazone 3. Die Einrichtung 6 enthält dabei eine Röntgenquelle zur Bestrahlung des Hilfssubstrates 2 und einen Fotodetektor zur Bestimmung der vom Hilfssubstrat reflektierten Röntgenstrahlung.

## Patentansprüche

1. Magnetron-Beschichtungsanlage, bestehend aus
• einem ersten Magnetron (5)
• einem Hilfssubstrat (2), angeordnet zwischen dieser ersten Beschichtungsquelle und dem Bereich, welcher zur Aufnahme des zu beschichtenden Substrates (1) vorgesehen ist
• ein Magnetron (3), wobei das Hilfssubstrat (2) eine Kathode für dieses Magnetron bildet
• Mittel zur Bestimmung der Massenbelegung (6) des Hilfssubstrates (2),
**dadurch gekennzeichnet, dass** das Hilfssubstrat dafür vorgesehen ist, mittels des ersten Magnetrons (5) darauf eine Metallschicht abzuscheiden, welche eine größere Massenzahl aufweist als die durchschnittliche Massenzahl des Materials des Hilfssubstrates.

2. Magnetron-Beschichtungsanlage nach Anspruch 1, **dadurch gekennzeichnet, dass** das Hilfssubstrat zylinderförmig ausgebildet und das Magnetron ein Stabkathodenmagnetron ist.

3. Magnetron-Beschichtungsanlage nach einem der Ansprüche 1 oder 2, **dadurch gekennzeichnet, dass** das erste Magnetron eine Abschirmung (4) aufweist.

4. Magnetron-Beschichtungsanlage nach einem der Ansprüche 1 bis 3, **dadurch gekennzeichnet, dass** die Mittel zur Bestimmung der Massenbelegung (6) eine Einrichtung zur Bestimmung der Röntgenfluoreszenz enthalten.

5. Magnetron-Beschichtungsanlage nach einem der Ansprüche 1 bis 4, **dadurch gekennzeichnet, dass** das Magnetron (2,3) mehrere Kathoden aufweist, welche jeweils ein Hilfssubstrat (2) enthalten.

6. Verfahren zur Abscheidung dünner Schichten, bei welchem mittels einer ersten Beschichtungsquelle eine Metallschicht auf ein Hilfssubstrat abgeschieden und dieses Hilfssubstrat als Kathode zur Beschichtung eines Substrates mittels eines Magnetrons verwendet und die Massenbelegung des Hilfssubstrates bestimmt wird, **dadurch gekennzeichnet, dass** die Metallschicht überwiegend aus einem Element besteht, welches eine größere Massenzahl aufweist als die durchschnittliche Massenzahl des Materials des Hilfssubstrates.

7. Verfahren nach Anspruch 6, **dadurch gekennzeichnet, dass** die abgeschiedene Schichtdicke auf dem Hilfssubstrat weniger als 100 nm beträgt.

8. Verfahren nach Anspruch 7, **dadurch gekennzeichnet, dass** die abgeschiedene Schichtdicke auf dem Hilfssubstrat weniger als 10 nm beträgt.

9. Verfahren nach einem der Ansprüche 6 bis 8, **dadurch gekennzeichnet, dass** die erste Beschichtungsquelle ein Magnetron ist und dass der Betrieb des ersten Magnetrons mit Inertgas und der Betrieb des zweiten Magnetrons mit Inert- und/oder Reaktivgas erfolgt.

10. Verfahren nach Anspruch 9, **dadurch gekennzeichnet, dass** das Inertgas Argon enthält und/oder das Reaktivgas Stickstoff und/oder Sauerstoff und/oder Methan enthält.

11. Verfahren nach einem der Ansprüche 6 bis 10, **dadurch gekennzeichnet, dass** die Massenbelegung auf dem Hilfstarget bestimmt wird, nachdem dieses als Kathode zur Beschichtung eines Substrates mittels des zweiten Magnetrons verwendet wurde.

12. Verfahren nach einem der Ansprüche 6 bis 11, **dadurch gekennzeichnet, dass** die Massenbelegung des Hilfstargets mittels Röntgenfluoreszenz bestimmt wird.

13. Verfahren nach einem der Ansprüche 6 bis 12, **dadurch gekennzeichnet, dass** das zweite Magnetron (2, 3) mit Gleichspannung oder gepulster Gleichspannung betrieben wird.

14. Verfahren nach einem der Ansprüche 6 bis 13, **dadurch gekennzeichnet, dass** das Magnetron (2, 3) als mehrere Kathoden aufweisendes Magnetron mit einer Frequenz von etwa 10 kHz bis etwa 100 kHz betrieben wird.

15. Verwendung des Verfahrens nach einem der Ansprüche 6 bis 14 zur Abscheidung einer Schicht auf dem Substrat, welche Titandioxid enthält.

## Claims

1. Magnetron coating plant, comprising
• a first magnetron (5)
• an auxiliary substrate (2) which is disposed between this first coating source and the region which is provided for receiving the substrate (1) which is to be coated
• a magnetron (3), the auxiliary substrate (2) forming a cathode for this magnetron
• means for determining the mass covering (6) of the auxiliary substrate (2),
**characterised in that** the auxiliary substrate is provided for depositing a metal layer thereupon by means of the first magnetron (5), which layer has a greater mass number than the average mass number of the material of the substrate.

2. Magnetron coating plant according to claim 1, **characterised in that** the auxiliary substrate has a cylindrical configuration and the magnetron is a rod cathode magnetron.

3. Magnetron coating plant according to one of the claims 1 or 2, **characterised in that** the first magnetron has a screen (4).

4. Magnetron coating plant according to one of the claims 1 to 3, **characterised in that** the means for determining the mass covering (6) contain a device for determining the X-ray fluorescence.

5. Magnetron coating plant according to one of the claims 1 to 4, **characterised in that** the magnetron (2, 3) has a plurality of cathodes which contain respectively an auxiliary substrate (2).

6. Method for depositing thin layers, in which a metal layer is deposited on an auxiliary substrate by means of a first coating source and this auxiliary substrate is used as cathode for coating a substrate by means of a magnetron, and the mass covering of the auxiliary substrate is determined, **characterised in that** the metal layer comprises predominantly an element which has a greater mass number than the average mass number of the material of the auxiliary substrate.

7. Method according to claim 6, **characterised in that** the deposited layer thickness on the auxiliary substrate is less than 100 nm.

8. Method according to claim 7, **characterised in that** the deposited layer thickness on the auxiliary substrate is less than 10 nm.

9. Method according to one of the claims 6 to 8, **characterised in that** the first coating source is a magnetron and **in that** the operation of the first magnetron is effected with inert gas and the operation of the second magnetron is effected with inert and/or reactive gas.

10. Method according to claim 9, **characterised in that** the inert gas contains argon and/or the reactive gas contains nitrogen and/or oxygen and/or methane.

11. Method according to one of the claims 6 to 10, **characterised in that** the mass covering on the auxiliary target is determined after the latter has been used as cathode for coating a substrate by means of the second magnetron.

12. Method according to one of the claims 6 to 11, **characterised in that** the mass covering of the auxiliary target is determined by means of X-ray fluorescence.

13. Method according to one of the claims 6 to 12, **characterised in that** the second magnetron (2, 3) is operated with direct voltage or pulsed direct voltage.

14. Method according to one of the claims 6 to 13, **characterised in that** the magnetron (2, 3) is operated as a magnetron which has a plurality of cathodes and with a frequency of approximately 10 kHz to approximately 100 kHz.

15. Use of the method according to one of the claims 6 to 14 for depositing a layer on the substrate, which layer contains titanium dioxide.

## Revendications

1. Installation de revêtement avec un magnétron comprenant :
- un premier magnétron (5),
- un substrat auxiliaire (2) placé entre cette première source de revêtement et la zone prévue pour recevoir le substrat (1) à revêtir,
- un magnétron (3) pour lequel le substrat auxiliaire (2) constitue la cathode,
- des moyens pour déterminer l'occupation massique (6) du substrat auxiliaire (2),
**caractérisée en ce que**
le substrat auxiliaire (2) est prévu pour recevoir une première couche métallique à l'aide du premier magnétron (5), couche dont le nombre de masse est supérieur au nombre de masse moyen de la matière du substrat auxiliaire.

2. Installation de revêtement à magnétron selon la revendication 1,
**caractérisée en ce que**
le substrat auxiliaire est de forme cylindrique et le magnétron est un magnétron à cathode en forme de tige.

3. Installation de revêtement à magnétron selon l'une des revendications 1 ou 2,
**caractérisée en ce que**
le premier magnétron comporte un capot de blindage (4).

4. Installation de revêtement à magnétron selon l'une des revendications 1 à 3,
**caractérisée en ce que**
les moyens pour déterminer l'occupation massique (6) comportent une installation pour déterminer la fluorescence aux rayons X.

5. Installation de revêtement à magnétron selon l'une des revendications 1 à 4,
**caractérisée en ce que**
le magnétron (2, 3) comporte plusieurs cathodes ayant chacune un substrat auxiliaire (2).

6. Procédé de dépôt de couche mince selon lequel, à l'aide d'une première source de revêtement on dépose une couche métallique sur un substrat auxiliaire et on utilise ce substrat auxiliaire comme cathode pour revêtir un substrat à l'aide d'un magnétron et on détermine l'occupation massique du substrat auxiliaire,
**caractérisé en ce que**
la couche métallique se compose principalement d'un élément ayant un nombre massique plus grand que le nombre massique moyen de la matière du substrat auxiliaire.

7. Procédé selon la revendication 6,
**caractérisé en ce que**
l'épaisseur de couche déposée sur le substrat auxiliaire est inférieure à 100 nm.

8. Procédé selon la revendication 7,
**caractérisé en ce que**
l'épaisseur de la couche déposée sur le substrat auxiliaire est inférieure à 10 nm.

9. Procédé selon l'une des revendications 6 à 8,
**caractérisé en ce que**
la première source de revêtement est un magnétron et le premier magnétron fonctionne avec du gaz inerte et le second magnétron fonctionne avec du gaz inerte et/ou un gaz réactif.

10. Procédé selon la revendication 9,
**caractérisé en ce que**
le gaz inerte contient de l'argon et/ou le gaz réactif contient de l'azote et/ ou de l'oxygène et/ ou du méthane.

11. Procédé selon l'une des revendications 6 à 10,
**caractérisé en ce qu'**
on détermine l'occupation massique sur la cible auxiliaire après avoir utilisé celle-ci comme cathode pour revêtir un substrat à l'aide du second magnétron.

12. Procédé selon l'une des revendications 6 à 11,
**caractérisé en ce qu'**
on détermine l'occupation massique de la cible auxiliaire par fluorescence aux rayons X.

13. Procédé selon l'une des revendications 6 à 12,
**caractérisé en ce qu'**
on fait fonctionner le second magnétron (2, 3) avec une tension continue ou une tension continue pulsée.

14. Procédé selon l'une des revendications 6 à 13,
**caractérisé en ce qu'**
on fait fonctionner le magnétron (2, 3) comme magnétron à plusieurs cathodes avec une fréquence d'environ 10 kHz jusqu'à environ 100 kHz.

15. Utilisation du procédé selon l'une des revendications 6 à 14,
pour déposer une couche contenant du dioxyde de titane sur le substrat.
